(19) **Europäisches Patentamt**
**European Patent Office**
**Office européen des brevets**

(11) **EP 4 709 065 A2**

(12) **EUROPEAN PATENT APPLICATION**

(43) Date of publication:
**11.03.2026 Bulletin 2026/11**

(21) Application number: **26153379.8**

(22) Date of filing: **19.02.2024**

(51) International Patent Classification (IPC):
**H05K 3/28** *(2006.01)*

(52) Cooperative Patent Classification (CPC):
(C-Sets available)
**B32B 15/08; B32B 15/082; B32B 15/20;**
**B32B 27/30; C08L 27/18; C08L 79/08;**
**H05K 1/0353;** H05K 2201/015; H05K 2201/0154
(Cont.)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **22.02.2023 JP 2023026291**

(62) Document number(s) of the earlier application(s) in
accordance with Art. 76 EPC:
**24740793.5 / 4 450 563**

(71) Applicant: **Daikin Industries, Ltd.**
**Osaka-shi, Osaka 530-0001 (JP)**

(72) Inventors:
• **Seki, Toyomitsu**
**Osaka-Shi, Osaka 530-0001 (JP)**
• **Maruhashi, Takuma**
**Osaka-Shi, Osaka 530-0001 (JP)**

• **Yamaguchi, Shuhei**
**Osaka-Shi, Osaka 530-0001 (JP)**
• **Komori, Masaji**
**Osaka-Shi, Osaka 530-0001 (JP)**
• **Yamauchi, Akiyoshi**
**Osaka-Shi, Osaka 530-0001 (JP)**

(74) Representative: **Hoffmann Eitle**
**Patent- und Rechtsanwälte PartmbB**
**Arabellastraße 30**
**81925 München (DE)**

Remarks:
This application was filed on 22.01.2026 as a
divisional application to the application mentioned
under INID code 62.

(54) **RESIN COMPOSITION, METHOD FOR PRODUCING RESIN COMPOSITION, PELLET, MOLDED PRODUCT, AND LAMINATE**

(57) Provided is a resin composition capable of producing a molded article with excellent impact strength. The resin composition contains an amorphous resin (A) belonging to super engineering plastics and a fluorine-containing copolymer (B), the amorphous resin (A) or the fluorine-containing copolymer (B) having an average dispersed particle size r1 and an average dispersed particle size r2 that is determined after measuring a melt flow rate in conformity with ASTM D1238 after preheating for five minutes and under a load of 5000 g at 380°C or at a temperature at which the resin composition melts or higher, the r1 and the r2 satisfying a ratio r2/r1 of lower than 1.70, where the r1 and the r2 are obtained by measuring the same resin or the same copolymer.

EP 4 709 065 A2

(52) Cooperative Patent Classification (CPC): (Cont.)

    C-Sets
    **C08L 27/18, C08L 79/08;**
    **C08L 79/08, C08L 27/18**

**Description**

TECHNICAL FIELD

The disclosure relates to resin compositions, methods for producing resin compositions, pellets, molded articles, and laminates.

BACKGROUND ART

Amorphous resins belonging to super engineering plastics are excellent in strength, heat resistance, and other properties, and therefore they are used in various products. Fluorine-containing copolymers are excellent in sliding properties, heat resistance, chemical resistance, solvent resistance, weather resistance, flexibility, electrical properties, and other properties, and therefore they are used in various products.
Patent Literature 1 describes that injection-molded articles with low surface peelability, high uniformity, and high strength can be obtained by using an amorphous polymer (amorphous resin) exhibiting its specific properties and a fluoropolymer (fluorine-containing copolymer) exhibiting its specific properties.

CITATION LIST

- Patent Literature

Patent Literature 1: JP 2001-72882 A

SUMMARY OF INVENTION

- Technical Problem

The disclosure provides a resin composition capable of producing a molded article with excellent impact strength.

- Solution to Problem

The disclosure (1) relates to a resin composition, containing:

an amorphous resin (A) belonging to super engineering plastics; and
a fluorine-containing copolymer (B),
the amorphous resin (A) or the fluorine-containing copolymer (B) having an average dispersed particle size r1 and an average dispersed particle size r2 that is determined after measuring a melt flow rate in conformity with ASTM D1238 after preheating for five minutes and under a load of 5000 g at 380°C or at a temperature at which the resin composition melts or higher,
the r1 and the r2 satisfying a ratio r2/r1 of lower than 1.70, where the r1 and the r2 are obtained by measuring the same resin or the same copolymer.

The disclosure (2) relates to the resin composition described in the disclosure (1),
wherein the amorphous resin (A) has a glass transition temperature of 190°C to 290°C.
The disclosure (3) relates to the resin composition described in the disclosure (1) or (2),
wherein the amorphous resin (A) has a continuous use temperature of 140°C or higher.
The disclosure (4) relates to the resin composition described in any one of the disclosures (1) to (3),
wherein the amorphous resin (A) has an imide structure.
The disclosure (5) relates to the resin composition described in the disclosure (4),
wherein the amorphous resin (A) has an amide structure and an imide structure.
The disclosure (6) relates to the resin composition described in the disclosure (4) or (5),
wherein the amorphous resin (A) is a thermoplastic polyimide.
The disclosure (7) relates to the resin composition described in any one of the disclosures (4) to (6),
wherein the amorphous resin (A) is polyetherimide.
The disclosure (8) relates to the resin composition described in any one of the disclosures (1) to (7),
wherein the fluorine-containing copolymer (B) has a melting point of 200°C to 323°C.
The disclosure (9) relates to the resin composition described in any one of the disclosures (1) to (8),
wherein the fluorine-containing copolymer (B) is a copolymer of tetrafluoroethylene and a perfluoroethylenic unsaturated compound represented by the following formula (1):

$$CF_2=CF-Rf^1 \qquad (1)$$

wherein $Rf^1$ is $-CF_3$ or $-ORf^2$, where $Rf^2$ is a C1-C5 perfluoroalkyl group.

The disclosure (10) relates to the resin composition described in the disclosure (9), wherein the perfluoroethylenic unsaturated compound is at least one selected from the group consisting of hexafluoropropylene and perfluoro(alkyl vinyl ether).

The disclosure (11) relates to the resin composition described in the disclosure (9) or (10), wherein the fluorine-containing copolymer (B) is at least one selected from the group consisting of a tetrafluoroethylene/hexafluoropropylene copolymer and a tetrafluoroethylene/perfluoro(alkyl vinyl ether) copolymer.

The disclosure (12) relates to the resin composition described in any one of the disclosures (1) to (11),

wherein the r2 is 2.0 $\mu$m or less when the r1 and the r2 are obtained by measuring the amorphous resin (A), or the r2 is 1.0 $\mu$m or less when the r1 and the r2 are obtained by measuring the fluorine-containing copolymer (B) .

The disclosure (13) relates to the resin composition described in any one of the disclosures (1) to (12), wherein the amorphous resin (A) and the fluorine-containing copolymer (B) are in a mass ratio (A): (B) of 99:1 to 10:90.

The disclosure (14) relates to the resin composition described in the disclosure (13), wherein the mass ratio (A): (B) is 80:20 to 20:80.

The disclosure (15) relates to the resin composition described in any one of the disclosures (1) to (14), wherein the resin composition has a phase structure including a continuous phase and a dispersed phase that contains a component constituting the continuous phase.

The disclosure (16) relates to a resin composition, containing:

a thermoplastic resin (X); and
a fluorine-containing copolymer (B),
the resin composition having a phase structure including a continuous phase and a dispersed phase that contains a component constituting the continuous phase, where one of the thermoplastic resin (X) and the fluorine-containing copolymer (B) forms the continuous phase and the other forms the dispersed phase.

The disclosure (17) relates to a method for producing the resin composition according to any one of claims 1 to 15, the method including
melt-kneading the amorphous resin (A) and the fluorine-containing copolymer (B) at a shear rate of 600/sec or higher determined using the following equation 1.

$$\text{Equation 1: } \gamma = \pi Dr/C$$

$\gamma$:    shear rate (/sec)
D:    screw outer diameter (mm)
r:    screw rotation speed (rpm)
C:    tip clearance (mm)

The disclosure (18) relates to the production method described in the disclosure (17),

wherein the shear rate is 800/sec or higher and 3000/sec or lower,
the duration of the melt-kneading is 5 to 300 seconds, and
the temperature in the melt-kneading is 260°C to 400°C.

The disclosure (19) relates to a pellet obtained by molding the resin composition described in any one of the disclosures (1) to (16).

The disclosure (20) relates to a molded article formed from the resin composition described in any one of the disclosures (1) to (16).

The disclosure (21) relates to the molded article described in the disclosure (20), having a Charpy impact strength of 5 kJ/$m^2$ or higher as measured with an impact tester in conformity with ASTM D6110-02.

The disclosure (22) relates to the molded article described in the disclosure (20) or (21), which is used as a material required to have dielectric properties.

The disclosure (23) relates to the molded article described in any one of the disclosures (20) to (22), which is a material for high-frequency circuit boards.

The disclosure (24) relates a laminate, including

metal foil; and
the molded article described in any one of the disclosures (20) to (23).

The disclosure (25) relates the laminate described in the disclosure (24),
wherein the metal foil is formed of copper.

- Advantageous Effects of Invention

According to the disclosure, a molded article with excellent impact strength can be produced.

DESCRIPTION OF EMBODIMENTS

The first resin composition of the disclosure contains an amorphous resin (A) belonging to super engineering plastics and a fluorine-containing copolymer (B), the amorphous resin (A) or the fluorine-containing copolymer (B) having an average dispersed particle size r1 and an average dispersed particle size r2 that is determined after measuring a melt flow rate in conformity with ASTM D1238 after preheating for five minutes and under a load of 5000 g at 380°C or at a temperature at which the resin composition melts or higher, the r1 and the r2 satisfying a ratio r2/r1 of lower than 1.70, where the r1 and the r2 are obtained by measuring the same resin or the same copolymer.

Fluorine-containing copolymers have a low compatibility with other resins. Upon molding a resin composition including a mixture of a fluorine-containing copolymer with other resins, the dispersed particles of the resin composition aggregate, so that the physical properties tend to decrease. The present inventors made intensive sturdies to solve the issue and paid attention to the shear rate during kneading. As a result, they found that an effective shear during the kneading enables production of a resin composition that can suppress the aggregation of dispersed particles during molding.

The first resin composition of the disclosure having the structure described above can suppress the aggregation of dispersed particles during molding and therefore can maintain good mechanical physical properties after it is molded. Thus, the resin composition can produce a molded article with excellent impact strength. Compared to a composition using the amorphous resin (A) alone, the resin composition can improve the flexibility and electric properties.

In the first resin composition of the disclosure, preferably, the fluorine-containing copolymer (B) is dispersed in the form of particles in the amorphous resin (A) or the amorphous resin (A) is dispersed in the form of particles in the fluorine-containing copolymer (B).

Generally, in an embodiment in which the fluorine-containing copolymer (B) is dispersed in the form of particles in the amorphous resin (A), the amorphous resin (A) forms the continuous phase, while the fluorine-containing copolymer (B) forms the dispersed phase. In an embodiment in which the amorphous resin (A) is dispersed in the form of particles in the fluorine-containing copolymer (B), the fluorine-containing copolymer (B) forms the continuous phase, while the amorphous resin (A) forms the dispersed phase. Generally, the former embodiment is provided when the amount of the amorphous resin (A) is larger than the amount of the fluorine-containing copolymer (B), while the latter embodiment is provided when the amount of the amorphous resin (A) is smaller than the amount of the fluorine-containing copolymer (B).

The r1 and the r2 may be obtained by measuring the amorphous resin (A) or by measuring the fluorine-containing copolymer (B) as long as they are obtained by measuring the same resin or the same copolymer.

The r1 and the r2 are usually obtained by measuring a resin or a copolymer that forms the dispersed phase. Thus, in an embodiment in which the fluorine-containing copolymer (B) is dispersed in the form of particles in the amorphous resin (A), the r1 and the r2 are obtained by measuring the fluorine-containing copolymer (B), while in an embodiment in which the amorphous resin (A) is dispersed in the form of particles in the fluorine-containing copolymer (B), the r1 and the r2 are obtained by measuring the amorphous resin (A).

The ratio r2/r1 in the first resin composition of the disclosure is lower than 1.70. The ratio r2/r1 increases when the amorphous resin (A) or the fluorine-containing copolymer (B) dispersed in the form of particles aggregates due to MFR measurement. Therefore, the ratio r2/r1 of lower than 1.70 indicates that the particles of the amorphous resin (A) or the fluorine-containing copolymer (B) after the MFR measurement are less likely to aggregate.

The ratio r2/r1 is lower than 1.70. To obtain a molded article with further excellent impact strength, the ratio is preferably 1.50 or lower, more preferably 1.40 or lower. The lower limit is not limited and may be, for example, 1.0.

When the r1 and the r2 are obtained by measuring the amorphous resin (A), the r2 is preferably 2.5 $\mu$m or less, more preferably 2.0 $\mu$m or less, still more preferably 1.5 $\mu$m or less. With a r2 within this range, a molded article with further excellent impact strength can be obtained. The lower limit is not limited and may be, for example, 0.01 $\mu$m.

When the r1 and the r2 are obtained by measuring the fluorine-containing copolymer (B), the r2 is preferably 2.0 $\mu$m or less, more preferably 1.5 $\mu$m or less, still more preferably 1.0 $\mu$m or less, particularly preferably 0.5 $\mu$m or less. With a r2 within this range, a molded article with further excellent impact strength can be obtained. The lower limit is not limited and may be, for example, 0.01 $\mu$m.

The r1 and r1 are determined by the following procedure.

First, a cut piece of a strand or a pellet of the resin composition is cut perpendicularly to the extrusion direction. The cross-section of the piece is observed using a confocal laser scanning microscope, and an obtained microscopic image is analyzed using image analysis software (Image J). The dispersed phase is selected and the equivalent circle diameter is determined. Circle diameters equivalent to 20 dispersed phases are calculated and averaged. The average is taken as r1 (average dispersed particle size).

The r2 is determined by performing the same operation on a strand or a pellet of the resin composition after MFR measurement.

The amorphous resin (A) belongs to super engineering plastics. Examples of such a resin include resins having a glass transition temperature within a specific range and resins having a continuous use temperature within a specific range. One amorphous resin (A) may be used, or two or more amorphous resins (A) may be used.

The glass transition temperature of the amorphous resin (A) is preferably 190°C or higher, more preferably 200C° or higher, still more preferably 210°C or higher but is preferably 290°C or lower, more preferably 250°C or lower, still more preferably 220°C or lower.

Herein, the glass transition temperature is measured with a temperature-increasing rate of 20°C/min using a differential scanning calorimeter (DSC) in conformity with JIS K 7121.

The continuous use temperature of the amorphous resin (A) is preferably 140°C or higher, more preferably 160°C or higher, still more preferably 170°C or higher. The upper limit is not limited, and a higher continuous use temperature is better. The upper limit of the continuous use temperature may be, for example, 260°C.

Herein, the continuous use temperature is measured while leaving the amorphous resin (A) in the air at a constant temperature for 40000 hours, and it is the temperature at which the physical property value has deteriorated by 50% from the initial value. The continuous temperature is measured in conformity with UL746B..

The amorphous resin (A) preferably has an imide structure. Examples of the amorphous resin (A) having an imide structure include polyimide (PI).

Herein, the term "polyimide" refers to a polycondensate having an imide structure in the main chain. The polyimide is preferably a thermoplastic polyimide (TPI), more preferably polyetherimide (PEI) because they have better moldability.

The amorphous resin (A) also preferably has an amide structure and an imide structure. Examples of the amorphous resin (A) having an amide structure and an imide structure include polyamideimide (PAI).

Herein, the term "polyamideimide" refers to a polycondensate having an amide structure and an imide structure in the main chain.

The amorphous resin (A) may be a resin other than the polyimide and polyamideimide described above. Examples of usable resins include polysulfone (PSU), polyethersulfone (PES), polyphenylsulfone (PPSU), and polyarylate (PAR).

The melt flow rate (MFR) of the amorphous resin (A) under a load of 5000 g at 380°C or at a temperature at which the amorphous resin (A) melts or higher is preferably 1 to 150 g/10 min, more preferably 5 to 130 g/10 min, still more preferably 10 to 100 g/10 min. With a melt flow rate within this range, a molded article with further excellent impact strength can be obtained.

The MFR of the amorphous resin (A) is measured in conformity with ASTM D1238 after preheating for five minutes and under a load of 5000 g at 380°C or at a temperature at which the amorphous resin (A) melts or higher. For example, the temperature at which the amorphous resin (A) melts or higher may be 400°C.

The fluorine-containing copolymer (B) is, for example, a polymer having a polymerized unit based on at least one fluorine-containing ethylenic monomer. The fluorine-containing copolymer (B) is preferably a melt-fabricable fluororesin. One fluorine-containing copolymer (B) may be used, or two or more fluorine-containing copolymers (B) may be used.

Examples of the fluorine-containing copolymer (B) include a tetrafluoroethylene (TFE)/hexafluoropropylene (HFP) copolymer (FEP), a TFE/HFP/perfluoro(alkyl vinyl ether) (PAVE) copolymer, a TFE/PAVE copolymer (PFA), an ethylene (Et)/TFE copolymer, an Et/TFE/HFP copolymer, polychlorotrifluoroethylene (PCTFE), a chlorotrifluoroethylene (CTFE)/TFE copolymer, a CTFE/TFE/PAVE copolymer, an Et/CTFE copolymer, a TFE/vinylidene fluoride (VdF) copolymer, a VdF/HFP/TFE copolymer, a VdF/HFP copolymer, polyvinylidene fluoride (PVdF), and polyvinyl fluoride (PVF). As long as it is melt-fabricable, low molecular weight polytetrafluoroethylene (PTFE) may also be used.

PAVE preferably contains a C1-C6 alkyl group, and examples thereof include perfluoro(methyl vinyl ether), perfluoro(ethyl vinyl ether), perfluoro(propyl vinyl ether), and perfluoro(butyl vinyl ether).

To obtain a molded article with further excellent impact strength, the fluorine-containing copolymer (B) is more preferably a copolymer of tetrafluoroethylene (TFE) and a perfluoroethylenic unsaturated compound represented by the

following formula (1):

$$CF_2=CF-Rf^1 \qquad (1)$$

wherein $Rf^1$ is $-CF_3$ or $-ORf^2$, where $Rf^2$ is a C1-C5 perfluoroalkyl group. When $Rf^1$ is $-ORf^2$, $Rf^2$ is preferably a C1-C3 perfluoroalkyl group.

To obtain a molded article with further excellent impact strength, the perfluoroethylenic unsaturated compound represented by the formula (1) is preferably at least one selected from the group consisting of hexafluoropropylene (HFP) and perfluoro(alkyl vinyl ether) (PAVE), more preferably at least one selected from the group consisting of hexafluoropropylene (HFP), perfluoro(methyl vinyl ether) (PMVE), perfluoro(ethyl vinyl ether) (PEVE), and perfluoro(propyl vinyl ether) (PPVE), still more preferably at least one selected from the group consisting of hexafluoropropylene and perfluoro(propyl vinyl ether).

To obtain a molded article with further excellent impact strength, the fluorine-containing copolymer (B) is preferably at least one selected from the group consisting of FEP and PFA.

The fluorine-containing copolymer (B) preferably contains 98 to 75% by mass of a polymerized unit (TFE unit) based on TFE and 2 to 25% by mass of the perfluoroethylenic unsaturated compound represented by the formula (1) relative to all polymerized units. The lower limit of the amount of TFE constituting the fluorine-containing copolymer (B) is more preferably 77% by mass, still more preferably 80% by mass, particularly preferably 83% by mass, more particularly preferably 85% by mass. The upper limit of the amount of TFE constituting the fluorine-containing copolymer (B) is more preferably 97% by mass, still more preferably 95% by mass, particularly preferably 92% by mass.

The lower limit of the amount of the perfluoroethylenic unsaturated compound represented by the formula (1) constituting the fluorine-containing copolymer (B) is more preferably 3% by mass, still more preferably 5% by mass. The upper limit of the amount of the perfluoroethylenic unsaturated compound represented by the formula (1) constituting the fluorine-containing copolymer (B) is more preferably 23% by mass, still more preferably 20% by mass, particularly preferably 17% by mass, further particularly preferably 15% by mass.

The fluorine-containing copolymer (B) is preferably a copolymer consisting of TFE and a perfluoroethylenic compound represented by the formula (1).

The fluorine-containing copolymer (B) preferably has a melt flow rate (MFR) of 0.1 to 100 g/10 min, more preferably 0.5 to 80 g/10 min, still more preferably 0.5 to 70 g/10 min. With MFR within this range, a molded article with further excellent impact strength can be obtained.

The fluorine-containing copolymer (B) may have a MFR of 7 g/10 min or higher.

The MFR of the fluorine-containing copolymer (B) is measured in conformity with ASTM D1238 at 380°C or at a temperature at which the fluorine-containing copolymer (B) melts or higher under a load of 5000 g using a melt indexer. For example, the temperature at which the fluorine-containing copolymer (B) melts or higher may be 400°C.

To improve the heat resistance of molded articles to be obtained, the fluorine-containing copolymer (B) preferably has a melting point of 200°C or higher, more preferably 220°C or higher, still more preferably 240°C or higher. To suppress thermal degradation during kneading, the fluorine-containing copolymer (B) preferably has a melting point of 323°C or lower, more preferably 320°C or lower, still more preferably 315°C or lower.

The melting point of the fluororesin (II) is determined as the temperature corresponding to the maximum value on a heat-of-fusion curve with a temperature-increasing rate of 10°C/min using a differential scanning calorimeter (DSC).

The fluorine-containing copolymer (B) may be treated with fluorine gas or ammonia by a known method in advance.

To reduce aggregation and coalescence of the fluorine-containing copolymer (B) phase and to easily control the rate of change of the dispersed particle size to a desired range in the first resin composition of the disclosure, a fluorine-containing copolymer containing a reactive functional group can be used. Specific examples of the reactive functional group include, but are not limited to, a vinyl group, an epoxy group, a carboxy group, an acid anhydride group, an ester group, an aldehyde group, a carbonyldioxy group, a haloformyl group, an alkoxycarbonyl group, an amino group, a hydroxy group, a styryl group, a methacrylic group, an acrylic group, a ureido group, a mercapto group, a sulfide group, an isocyanate group, and a hydrolyzable silyl group. Preferred among these include at least one selected from the group consisting of an epoxy group, a carboxy group, an acid anhydride group, an amino group, and a hydroxyl group, with at least one selected from the group consisting of a carboxy group and an acid anhydride group being preferred. The fluorine-containing copolymer may contain two or more of these reactive functional groups. The reactive functional group(s) may be introduced into either a main chain end or a side chain of the fluorine-containing copolymer.

The fluorine-containing copolymer containing a reactive functional group may have any functional group content. The amount is preferably 0.01 mol% to 15 mol% or less to sufficiently proceed the reaction and to prevent deterioration of the fluidity.

The fluorine-containing copolymer (B) may not contain a reactive functional group in its structure. The fluorine-containing copolymer (B) containing no reactive functional group in its structure can be obtained by fluorination of an end thereof, for example.

In the first resin composition of the disclosure, a mass ratio (A): (B) of the amorphous resin (A) and the fluorine-containing copolymer (B) is not limited but is preferably, for example, 99:1 to 10:90.

The upper limit of the mass ratio of the amorphous resin (A) in the mass ratio is preferably 95, more preferably 80, while the lower limit is preferably 20, more preferably 35, still more preferably 40. The upper limit of the mass ratio of the fluorine-containing copolymer (B) is preferably 80, more preferably 65, still more preferably 60, while the low limit is preferably 5, more preferably 20.

The first resin composition of the disclosure preferably has a phase structure including a continuous phase and a dispersed phase that contains a component constituting the continuous phase. With such a structure, a molded article with further excellent impact strength can be obtained.

The amorphous resin (A) and the fluorine-containing copolymer (B) may be the continuous phase and the dispersed phase, respectively, or vice versa.

The presence of the component constituting the dispersed phase in the first resin composition of the disclosure may be analyzed by any method, for example, by infrared spectroscopy (IR). Specifically, in IR analysis of the dispersed phase isolated from the resin composition in conformity with JIS K 0117:2017, detection of a peak of the component constituting the continuous phase as well as a peak of the component constituting the dispersed phase indicates that the component constituting the continuous phase is present in the dispersed phase.

The amount of the component constituting the continuous phase present in the dispersed phase is not limited.

The first resin composition of the disclosure preferably has a melt flow rate (MFR) of 0.1 to 200 g/10 min, more preferably 1 to 150 g/10 min at 380°C or at a temperature at which the resin composition melts or higher. The resin composition having a MFR within this range is further excellent in fluidity. With a MFR lower than this range, the molding processibility may be poor. With a MFR higher than this range, desired performance may not be achieved.

The MFR of the first resin composition of the disclosure is a value determined in conformity with ASTM D1238 after preheating for five minutes and under a load of 5000 g at 380°C or at a temperature at which the resin composition melts or higher. For example, the temperature at which the resin composition melts or higher may be 400°C.

The first resin composition of the disclosure preferably has a relative permittivity of 3.0 or lower, more preferably 2.9 or lower, still more preferably 2.7 or lower. The lower limit of the relative permittivity is preferably, but not limited to, 2.1 or higher.

The relative permittivity is a value determined by a cavity resonator perturbation method.

The first resin composition of the disclosure preferably has a dielectric tangent of 0.006 or less, more preferably 0.005 or less, still more preferably 0.004 or less. The lower limit of the dielectric tangent is preferably, but not limited to, 0.0001 or more.

The dielectric tangent is a value determined by a cavity resonator perturbation method.

The first resin composition of the disclosure may further contain an optional component, if needed, other than the amorphous resin (A) and the fluorine-containing copolymer (B). Non-limiting examples of the optional component other than the amorphous resin (A) and the fluorine-containing copolymer (B) include fibrous reinforcements such as whiskers (e.g., potassium titanate), glass fiber, asbestos fiber, carbon fiber, ceramic fiber, potassium titanate fiber, aramid fiber, and other high-strength fibers; inorganic fillers such as talc, mica, clay, carbon powder, graphite, artificial graphite, natural graphite, and glass beads; colorants; usually used inorganic or organic fillers such as flame retarders; lubricants such as silicone oil and molybdenum disulfide; pigments; conducting agents such as carbon black; impact resistance improvers such as rubber; lubricants such as magnesium stearate; ultraviolet absorbers such as benzotriazole compounds; foaming agents such as boron nitride; and other additives.

These additives in amounts that do not impair the effects of the disclosure may be added to the amorphous resin (A) as a raw material or to the fluorine-containing copolymer (B) as a raw material. Also, these additives in amounts that do not impair the effects of the disclosure may be added to the raw materials in a molten state by, for example, side feeding upon kneading the amorphous resin (A) and the fluorine-containing copolymer (B).

Fibrous filler (C)

The first resin composition of the disclosure preferably further contains a fibrous filler. Examples of the fibrous filler used in the resin composition of the disclosure include fibrous inorganic fillers such as glass fiber, carbon fiber, carbon milled fiber, metal fiber, asbestos, rock wool, ceramics fiber, slag fiber, potassium titanate whisker, boron whisker, aluminum borate whisker, calcium carbonate whisker, titanium oxide whisker, wollastonite, xonotlite, palygorskite (attapulgite), and sepiolite; heat resistant fibrous organic fillers which are typified by heat resistant organic fibers, such as aramid fiber, polyimide fiber, and polybenzothiazole fiber; and fibrous fillers prepared by coating the surfaces of these fillers with a different material such as a metal or a metal oxide. Examples of the fillers prepared by coating the surfaces of the exemplified fillers with a different material include metal-coated glass fiber and metal-coated carbon fiber. The surfaces may be coated with a different material by any method. Examples of the method include known plating processes such as electrolytic plating, electroless plating, and melt plating; a vacuum deposition process; an ion plating process; CVD processes such as thermal CVD, MOCVD, and plasma CVD; a PVD process; and a sputtering process. Preferred among these fibrous fillers include at least one selected from the group consisting of glass fiber, carbon fiber, carbon milled fiber, and aramid fiber, with at least one selected from the group consisting of glass fiber and carbon fiber being more preferred.

The fibrous filler preferably has a fiber diameter of 0.1 to 20 $\mu$m. The upper limit of the fiber diameter is more preferably 18 $\mu$m, still more preferably 15 $\mu$m. The lower limit of the fiber diameter is more preferably 1 $\mu$m, still more preferably 6 $\mu$m. The fiber diameter indicates the number average fiber diameter. The number average fiber diameter is a value calculated from scanning electron microscopic images of the residues collected after the molded article is dissolved in a solvent or after the resin is decomposed with a basic compound and the ash residues collected after the molded article is burned into ashes in a crucible.

When the fibrous filler in the resin composition of the disclosure is glass fiber, the glass fiber may have any of a variety of glass compositions such as compositions of A-glass, C-glass, and E-glass. Such glass filler may contain a component such as $TiO_2$, $SO_3$, or $P_2O_5$, if needed. Preferred among these is E-glass (alkali-free glass). The glass fiber is preferably surface-treated with a known surface-treating agent such as a silane coupling agent, a titanate coupling agent, or an aluminate coupling agent to improve the mechanical strength. Also, the glass fiber is preferably bundled with a resin such as an olefinic resin, a styrene resin, an acrylic resin, a polyester resin, an epoxy resin, or a urethane resin. Particularly preferred are an epoxy resin and a urethane resin to increase the mechanical strength. The bundled glass fiber contains a sizing agent attached thereto preferably in an amount of 0.1 to 3% by mass, more preferably in an amount of 0.2 to 1% by mass based on 100% by mass of the glass fiber. The fibrous filler used in the resin composition of the disclosure may be glass fiber with a flat cross-section. The glass fiber with a flat cross-section preferably has an average major axis of the fiber cross-section of 10 to 50 $\mu$m, more preferably 15 to 40 $\mu$m, still more preferably 20 to 35 $\mu$m, and an average of the ratios of the major axis to the minor axis (major axis/minor axis) is preferably 1.5 to 8, more preferably 2 to 6, still more preferably 2.5 to 5. Use of a glass fiber with a flat cross-section in which the average of the ratios of the major axis to the minor axis is within this range leads to greater improvement in anisotropy than use of fiber with a non-circular cross-section in which the average of the ratios of the major axis to the minor axis is less than 1.5. Examples of the shape of the flat cross-section include a flat shape, an elliptical shape, an eye-brow shape, a trefoil shape, and a non-circular shape similar to any of these shapes. To improve the mechanical strength and the low anisotropy, a flat shape is preferred among these. The glass fiber with a flat cross-section preferably has a ratio between an average fiber length and an average fiber diameter (aspect ratio) of 2 to 120, more preferably 2.5 to 70, still more preferably 3 to 50. With a ratio between the fiber length and the average fiber diameter of lower than 2, an effect of improving the mechanical strength may be poor. With a ratio between the fiber length and the average fiber diameter of higher than 120, the anisotropy may be high and the appearance of the molded article may be poor. The average fiber diameter of the glass fiber with a flat cross-section is the number-average fiber diameter obtained when the flat cross-sectional shape is converted into a true circular shape having the same area as the flat cross-sectional shape. The average fiber length refers to the number average fiber length of the fiber in the resin composition of the disclosure. The number average fiber length is a value calculated using an image analyzer from optical microscopic images of the residual fillers collected after the molded article is subjected to treatment such as ashing at high temperature, dissolution in a solvent, or decomposition with chemicals. The value is obtained without counting fibers having a length not longer than the fiber diameter.

The fibrous filler (C) is preferably present in an amount of 0 to 50% by mass, more preferably 5 to 40% by mass, still more preferably 10 to 30% by mass relative to the resin composition of the disclosure.

(Different additive)

To improve the design, for example, of the first resin composition of the disclosure, additives used in the improvement are advantageously used. These additives are described in detail below.

Dye and pigment (D)

The first resin composition of the disclosure may further contain any of a variety of dyes and pigments to obtain a molded article exhibiting a variety of design. Examples of dyes and pigments to be used in the resin composition of the disclosure include perylene-based dyes, coumarin-based dyes, thioindigo-based dyes, anthraquinone-based dyes, thioxanthone-based dyes, ferrocyanides such as Prussian blue, perinone-based dyes, quinoline-based dyes, quinacridone-based dyes, dioxazine-based dyes, isoindolinone-based dyes, and phthalocyanine-based dyes. The resin composition of the disclosure may further contain a metallic pigment to achieve better metallic color. A preferred metallic pigment is aluminum powder. Mixing a fluorescent brightener or other light-emitting fluorescent dyes can provide a better design effect which brings out the luminescent color.

Compound having heat-absorbing ability (E)

The first resin composition of the disclosure may contain a compound having a heat-absorbing ability. Preferred examples of this compound include various metal compounds having an excellent near-infrared light absorbing ability such as a phthalocyanine-based near-infrared absorber, a metal oxide-based near-infrared absorber (e.g., ATO, ITO, iridium oxide, ruthenium oxide, imonium oxide, or titanium oxide), and a metal boride-based or tungsten oxide-based near-infrared absorber such as lanthanum boride, cerium boride, or tungsten boride; and carbon filler. An example of the phthalocyanine-based near-infrared absorber is MIR-362 commercially available from Mitsui Chemicals, Inc., which is easily available. Examples of the carbon filler include carbon black, graphite (including both natural and artificial), and fullerene. Preferred are carbon black and graphite. These may be used alone or in combinations of two or more thereof. The phthalocyanine-based near-infrared absorber is preferably present in an amount of 0.0005 to 0.2 parts by mass, more preferably 0.0008 to 0.1 parts by mass, still more preferably 0.001 to 0.07 parts by mass relative to 100 parts by mass of the resin composition of the disclosure. The metal oxide-based near-infrared absorber, metal boride-based near-infrared absorber, and carbon filler are each preferably present in an amount of 0.1 to 200 ppm (proportion by mass), more preferably 0.5 to 100 ppm, in the resin composition of the disclosure.

Highly light-reflective white pigment (F)

The first resin composition of the disclosure may contain a highly light-reflective white pigment to achieve a light-reflecting effect. Such a white pigment is particularly preferably a titanium dioxide pigment, especially titanium dioxide treated with an organic surface-treating agent such as silicone. The highly light-reflective white pigment is preferably present in an amount of 3 to 30 parts by mass, more preferably 8 to 25 parts by mass, relative to 100 parts by mass of the resin composition. Two or more highly light-reflective white pigments may be used in combination.

Ultraviolet absorber (G)

The first resin composition of the disclosure may contain an ultraviolet absorber to achieve weather resistance. Specific examples of the ultraviolet absorber include benzophenone-based ultraviolet absorbers such as 2,4-dihydroxybenzophenone, 2-hydroxy-4-methoxybenzophenone, 2-hydroxy-4-octoxybenzophenone, 2-hydroxy-4-benzyloxybenzophenone, 2-hydroxy-4-methoxy-5-sulfoxybenzophenone, 2,2'-dihydroxy-4-methoxybenzophenone, 2,2',4,4'-tetrahydroxybenzophenone, 2,2'-dihydroxy-4,4'-dimethoxybenzophenone, 2,2'-dihydroxy-4,4'-dimethoxy-5-sodiumsulfoxybenzophenone, bis(5-benzoyl-4-hydroxy-2-methoxyphenyl)methane, 2-hydroxy-4-n-dodecyloxybenzophenone, and 2-hydroxy-4-methoxy-2'-carboxybenzophenone. Specific examples of the ultraviolet absorber include benzotriazole-based ultraviolet absorbers such as 2-(2-hydroxy-5-methylphenyl)benzotriazole, 2-(2-hydroxy-5-tert-octylphenyl)benzotriazole, 2-(2-hydroxy-3,5-dicumylphenyl) phenylbenzotriazole, 2-(2-hydroxy-3-tert-butyl-5-methylphenyl)-5-chlorobenzotriazole, 2,2'-methylenebis[4-(1,1,3,3-tetramethylbutyl)-6-(2H-benzotriazol-2-yl)phenol], 2-(2-hydroxy-3,5-di-tert-butylphenyl)benzotriazole, 2-(2-hydroxy-3,5-di-tert-butylphenyl)-5-chlorobenzotriazole, 2-(2-hydroxy-3,5-di-tert-amylphenyl)benzotriazole, 2-(2-hydroxy-5-tert-octylphenyl)benzotriazole, 2-(2-hydroxy-5-tert-butylphenyl)benzotriazole, 2-(2-hydroxy-4-octoxyphenyl)benzotriazole, 2,2'-methylenebis(4-cumyl-6-benzotriazolephenyl), 2,2'-p-phenylenebis(1,3-benzoxazin-4-one), 2-[2-hydroxy-3-(3,4,5,6-tetrahydrophthalimidomethyl)-5-methylphenyl]benzotriazole, and polymers having a 2-hydroxyphenyl-2H-benzotriazole skeleton such as a copolymer of 2-(2'-hydroxy-5-methacryloxyethylphenyl)-2H-benzotriazole and a vinyl-based monomer copolymerizable with this monomer and a copolymer of 2-(2'-hydroxy-5-acryloxyethylphenyl)-2H-benzotriazole and a vinyl-based monomer copolymerizable with this monomer. Specific examples of the ultraviolet absorber include hydroxyphenyltriazine-based ultraviolet absorbers such as 2-(4,6-diphenyl-1,3,5-triazin-2-yl)-5-hexyloxyphenol, 2-(4,6-diphenyl-1,3,5-triazin-2-yl)-5-methyloxyphenol, 2-(4,6-diphenyl-1,3,5-triazin-2-yl)-5-ethyloxyphenol, 2-(4,6-diphenyl-1,3,5-triazin-2-yl)-5-propyloxyphenol, and 2-(4,6-diphenyl-1,3,5-triazin-2-yl)-5-butyloxyphenol. Examples also include compounds obtainable by replacing the phenyl group in any of the above exemplified compounds by a 2,4-dimethylphenyl group, such as 2-(4,6-bis(2,4-dimethylphenyl)-1,3,5-triazin-2-yl)-5-hexyloxyphenol. Specific examples of the ultraviolet absorber include cyclic imino ester-based ultraviolet absorbers such as 2,2'-p-phenylenebis(3,1-benzoxazin-4-one), 2,2'-m-phenylenebis(3,1-benzoxazin-4-one), and 2,2'-p,p'-diphenylenebis(3,1-benzoxazin-4-one). Specific examples of the ultraviolet absorber also include cyanoacrylate-based ultraviolet absorbers such as 1,3-bis-[(2'-cyano-3',3'-diphenylacryloyl)oxy]-2,2-bis[(2-cyano-3,3-diphenylacryloyl)oxy]methyl)propane and 1,3-bis-[(2-cyano-3,3-diphenylacryloyl)oxy]benzene. The ultraviolet absorber may be a polymer-type ultraviolet absorber that is in the form of a copolymer of an ultraviolet absorptive monomer and/or a light-stable monomer with a monomer such as an alkyl (meth)acrylate as a result of having a structure of a radically polymerizable monomer compound. Preferred examples of the ultraviolet absorptive monomer include compounds containing a benzotriazole skeleton, a benzophenone skeleton, a triazine skeleton, a cyclic imino ester skeleton, or a cyanoacrylate skeleton in an ester substituent of a (meth)acrylic acid ester. In view of the ultraviolet absorbing ability, preferred among these are benzotriazole-based ultraviolet absorbers and hydroxyphenyltriazine-based ultraviolet absorbers. In view of the heat resistance and hue, preferred are cyclic imino ester-based ultraviolet absorbers and cyanoacrylate-based ultraviolet absorbers. Specific examples thereof include "Kemisorb 79" available from Chemipro Kasei Kaisha, Ltd. and "Tinuvin 234" available from BASF Japan Ltd. The ultraviolet absorbers may be used alone or in the form of a mixture of two or more thereof.

The ultraviolet absorber is preferably present in an amount of 0.01 to 3 parts by mass, more preferably 0.01 to 1 part by mass, still more preferably 0.05 to 1 part by mass, particularly preferably 0.05 to 0.5 parts by mass, relative to 100 parts by mass of the resin composition of the disclosure.

Antistatic agent (H)

The first resin composition of the disclosure may need to have antistatic performance in some cases. In such cases, the first resin composition of the disclosure preferably contains an antistatic agent. Examples of the antistatic agent include (1) phosphonium organosulfonates such as phosphonium arylsulfonates typified by phosphonium dodecylbenzenesulfonate, and phosphonium alkylsulfonates; and phosphonium borates such as phosphonium tetrafluoroborate. The phosphonium salt is appropriately present in an amount of 5 parts by mass or less, preferably 0.05 to 5 parts by mass, more preferably 1 to 3.5 parts by mass, still more preferably 1.5 to 3 parts by mass, relative to 100 parts by mass of the resin composition of the disclosure. Examples of the antistatic agent include (2) organosulfonic acid alkali (alkaline earth) metal salts such as lithium organosulfonates, sodium organosulfonates, potassium organosulfonates, caesium organosulfonates, rubidium organosulfonates, calcium organosulfonates, magnesium organosulfonates, and barium organosulfonates. These metal salts can also be used as flame retarders, as described above. Specific examples of the metal salts include metal salts of dodecylbenzenesulfonic acid and metal salts of perfluoroalkanesulfonic acids. The organosulfonic acid alkali (alkaline earth) metal salt is appropriately present in an amount of 0.5 parts by mass or less, preferably 0.001 to 0.3 parts by mass, more preferably 0.005 to 0.2 parts by mass, relative to 100 parts by mass of the resin composition of the disclosure. Particularly preferred are salts of alkali metals such as potassium, caesium, and rubidium.

Examples of the antistatic agent include (3) ammonium organosulfonates such as ammonium alkylsulfonates and ammonium arylsulfonates. The ammonium salt is appropriately present in an amount of 0.05 parts by mass or less relative to 100 parts by mass of the resin composition of the disclosure. Examples of the antistatic agent include (4) polymers containing a poly(oxyalkylene) glycol component as a constituent, such as polyether ester amide. The polymer is appropriately present in an amount of 5 parts by mass or less relative to 100 parts by mass of the resin composition of the disclosure.

Filler (I)

The first resin composition of the disclosure may contain any of a variety of fillers, other than fibrous fillers, known as reinforcing filler. Examples of such fillers include a variety of platy filler and powdery filler. The platy filler means filler in the form of a plate including one having a rough surface and one having a curved plate. The powdery filler means filler having a shape other than these shapes, including filler with indefinite shapes.

Preferred examples of the platy filler include glass flakes, talc, mica, kaolin, metal flakes, carbon flakes, and graphite, and platy filler prepared by coating the surface of any of these fillers with a different material such as a metal or a metal oxide. The particle size thereof is preferably 0.1 to 300 μm. For filler having a particle size within a range up to about 10 μm, the particle size corresponds to the median size (D50) in a particle size distribution determined by X-ray transmission that is one of liquid sedimentation techniques. For filler having a particle size within a range of 10 to 50 μm, the particle size corresponds to the median size (D50) in the particle size distribution determined by laser diffraction/scattering. For filler having a particle size within a range of 50 to 300 μm, the particle size corresponds to the particle size determined by vibration sieving. The particle size is the value in the resin composition. The platy filler may be surface-treated with any of a variety of coupling agents such as silane-based coupling agents, titanate-based coupling agents, aluminate-based coupling agents, and zirconate-based coupling agents. Alternatively, the platy filler may be a granulated product prepared by bundling the platy filler with any of a variety of resins such as olefinic resin, styrenic resin, acrylic resin, polyester-based resin, epoxy-based resin, and urethane-based resin or a higher fatty acid ester or by compressing the platy filler.

Different resin and/or elastomer (J)

The first resin composition of the disclosure may contain a small proportion of a different resin and/or elastomer instead of part of the resin component to the extent that the effects of the disclosure are not impaired and can be achieved. The different resin and/or elastomer is preferably added in an amount of 20 parts by mass or less, more preferably 10 parts by mass or less, still more preferably 5 parts by mass or less, most preferably 3 parts by mass or less, relative to 100 parts by mass of the resin composition of the disclosure. Examples of the different resin include polyester resins such as polyethylene terephthalate and polybutylene terephthalate, and resins such as polyamide resin, polyimide resin, polyetherimide resin, polyurethane resin, silicone resin, polyphenylene ether resin, polyphenylene sulfide resin, polysulfone resin, polymethacrylate resin, phenol resin, and epoxy resin. Examples of the different elastomer include isobutylene-isoprene rubber, styrene-butadiene rubber, ethylene-propylene rubber, acrylic elastomers, polyester-based elastomers, polyamide-based elastomers, and core-shell elastomers such as methyl methacrylate-styrene-butadiene (MBS) rubber, methyl methacrylate-butadiene (MB) rubber, and methyl methacrylate-acrylonitrile-styrene (MAS) rubber, fluororubber, and a fluorine-containing elastomer.

Different additive (K)

The first resin composition of the disclosure may contain a different additive such as a fluidity improver, an antibacterial agent, a dispersant such as a liquid paraffin, a light-catalytic soil resistant agent, or a photochromic agent.

The total amount of the amorphous resin (A) and the fluorine-containing copolymer (B) in the first resin composition of the disclosure is preferably 100% by mass to 50% by mass. With a total amount of less than 50% by mass, sufficient impact strength or sufficient flexibility may not be obtained.

The total amount of the amorphous resin (A) and the fluorine-containing copolymer (B) in the first resin composition of the disclosure may be 90% by mass or more, 95% by mass or more, 99% by mass or more, 99.5% by mass or more, or 99.9% by mass or more.

The second resin composition of the disclosure has a phase structure including a continuous phase and a dispersed phase that contains a component constituting the continuous phase, where one of the thermoplastic resin (X) and the fluorine-containing copolymer (B) forms the continuous phase and the other forms the dispersed phase.

Like the first resin composition of the disclosure, the second resin composition of the disclosure having the structure described above can suppress the aggregation of dispersed particles during molding and therefore can maintain good mechanical physical properties after it is molded. Thus, the resin composition can produce a molded article with excellent impact strength. Compared to a composition using the thermoplastic resin (X) alone, the resin composition can improve the flexibility and electric properties.

The presence of the component constituting the dispersed phase in the second resin composition of the disclosure may be analyzed by any method, for example, by the same method described for the first resin composition of the disclosure.

The amount of the component constituting the continuous phase present in the dispersed phase is not limited.

In the second resin composition of the disclosure, preferably, the fluorine-containing copolymer (B) is dispersed in the form of particles in the thermoplastic resin (X) or the thermoplastic resin (X) is dispersed in the form of particles in the fluorine-containing copolymer (B) .

Generally, in an embodiment in which the fluorine-containing copolymer (B) is dispersed in the form of particles in the thermoplastic resin (X), the thermoplastic resin (X) forms the continuous phase and the fluorine-containing copolymer (B) forms the dispersed phase. In an embodiment in which the thermoplastic resin (X) is dispersed in the form of particles in the fluorine-containing copolymer (B), the fluorine-containing copolymer (B) forms the continuous phase, and the thermoplastic resin (X) forms the dispersed phase. Generally, the former embodiment is provided when the amount of the thermoplastic resin (X) is larger than the amount of the fluorine-containing copolymer (B), while the latter embodiment is provided when the amount of the thermoplastic resin (X) is smaller than the amount of the fluorine-containing copolymer (B).

In the second resin composition of the disclosure, a ratio r2/r1 between the average dispersed particle sizes r1 of the thermoplastic resin (X) and the fluorine-containing copolymer (B) and the respective average dispersed particle sizes r2 of the thermoplastic resin (X) and the fluorine-containing copolymer (B) determined after measuring a melt flow rate (MFR) in conformity with ASTM D1238 after preheating for five minutes and under a load of 5000 g at 380°C or at a temperature at which the resin composition melts or higher is preferably lower than 1.70, more preferably 1.50 or lower, still more preferably 1.40 or lower. The lower limit is not limited and may be, for example, 1.0.

The r1 and the r2 may be obtained by measuring the thermoplastic resin (X) or by measuring the fluorine-containing copolymer (B) as long as they are obtained by measuring the same resin or the same copolymer. For example, the temperature at which the thermoplastic resin (X) melts or higher may be 400°C.

When the r1 and the r2 are obtained by measuring the thermoplastic resin (X), the r2 is preferably 2.5 $\mu$m or less, more preferably 2.0 $\mu$m or less, still more preferably 1.5 $\mu$m or less. With a r2 within this range, a molded article with further excellent impact strength can be obtained. The lower limit is not limited and may be, for example, 0.01 $\mu$m.

When the r1 and the r2 are obtained by measuring the fluorine-containing copolymer (B), the r2 is preferably 2.0 $\mu$m or less, more preferably 1.5 $\mu$m or less, still more preferably 1.0 $\mu$m or less. With a r2 within this range, a molded article with further excellent impact strength can be obtained. The lower limit is not limited and may be, for example, 0.01 $\mu$m.

Examples of the fluorine-containing copolymer (B) include those described for the first resin composition of the disclosure.

The thermoplastic resin (X) may suitably be the amorphous resin (A) described for the first resin composition of the disclosure.

The thermoplastic resin (X) may be a resin other than the amorphous resin (A). Examples of resins other than the amorphous resin (A) include crystalline resins belonging to super engineering plastics.

Examples of crystalline resins belonging to super engineering plastics include aromatic polyether ketone resins, polyphenylene sulfide (PPS), liquid crystal polymers (LCP), and polyphthalamide (PPA).

The mass ratio (X): (B) of the thermoplastic resin (X) and the fluorine-containing copolymer (B) in the second resin composition of the disclosure is not limited but is preferably, for example, 99:1 to 10:90.

The upper limit of the mass ratio of the thermoplastic resin (X) in the mass ratio is preferably 95, more preferably 80, while the lower limit is preferably 20, more preferably 35, still more preferably 40. The upper limit of the mass ratio of the fluorine-containing copolymer (B) is preferably 80, more preferably 65, still more preferably 60, while the lower limit is preferably 5, more preferably 20.

The preferred ranges of the MFR, relative permittivity, and dielectric tangent in the second resin composition of the disclosure are the same as those described for the first resin composition of the disclosure.

The second resin composition of the disclosure may contain an optional component, if needed, other than the fluorine-containing copolymer (B) and the thermoplastic resin (X). Examples of usable components other than the fluorine-containing copolymer (B) and the thermoplastic resin (X) include those described for the first resin composition of the disclosure.

For example, the first resin composition of the disclosure can be produced by melt-kneading while applying a high shear force to the amorphous resin (A) and the fluorine-containing copolymer (B). For example, the second resin composition of the disclosure can be produced by melt-kneading while applying a high shear force to the thermoplastic resin (X) and the fluorine-containing copolymer (B). Specifically, the resin compositions can be produced by melt-kneading at a shear rate of 600/sec or higher determined using the equation 1 below.

The disclosure also provides a method for producing a resin composition including melt-kneading the amorphous resin (A) and the fluorine-containing copolymer (B) at a shear rate of 600/sec or higher determined using the following equation 1.

$$\text{Equation 1: } \gamma = \pi Dr/C$$

$\gamma$:  shear rate (/sec)
D:  screw outer diameter (mm)
r:  screw rotation speed (rpm)
C:  tip clearance (mm)

The disclosure also provides a method for producing a resin composition including melt-kneading the thermoplastic resin (X) and the fluorine-containing copolymer (B) at a shear rate of 600/sec or higher determined using the equation 1.

The shear rate is preferably 700/sec or higher, more preferably 800/sec or higher, further more preferably 900/sec or higher, further more preferably 1400/sec or higher, further more preferably 1500/sec or higher, further more preferably 1600/sec or higher. With such a shear rate, the resin composition to be obtained has further excellent flowability, and also a molded article with further excellent impact strength can be obtained. The upper limit is not limited and may be, for example, 3000/sec.

The melt-kneading is preferably performed while applying a high shear force to the amorphous resin (A) and the fluorine-containing copolymer (B) or the thermoplastic resin (X) and the fluorine-containing copolymer (B). The melt-kneading may be performed with any apparatus, and may be performed even with a conventionally known apparatus such as a twin screw extruder, a single screw extruder, a multi-screw extruder, a roll kneader such as a tandem extruder or a batch kneader, a labo plastomill, a Banbury mixer, a pressurizing kneader, or a blending mill if kneading conditions (e.g., special screw, high rotation speed, and narrow clearance) are controlled. This enables dispersion of the fluorine-containing copolymer in the amorphous resin or the thermoplastic resin (X) or dispersion of the amorphous resin or the thermoplastic resin (X) in the fluorine-containing copolymer in the order of submicrometers and can reduce the behavior of the amorphous resin or the fluorine-containing copolymer to cause aggregation during molding. As a result, the resulting resin composition can provide a molded article with further excellent impact resistance. To apply a high shear force, a twin-screw extruder or a high shear processor (reflux high shear processor) including a kneading section provided with an internal return screw is preferably used.

The internal return screw is a screw provided with a return hole along the central axis of the screw from the tip toward the back end. In a high shear processor including a kneading section provided with an internal return screw, a molten resin charged into the kneading section is circulated such that it is sent toward the tip along with the rotation of the internal return screw, flows into the return hole through an inlet on the tip to the back side and exits through an outlet, and is again sent toward the tip along with the rotation of the internal return screw. This circulation can highly disperse and mix the molten resin and reduce the size of the dispersed phase. Examples of the high shear processor include devices disclosed in JP 2005-313608 A and JP 2011-046103 A.

When the kneader is a twin-screw extruder, it is preferably a twin-screw extruder having a large L/D screw structure. The screw structure of a twin-screw extruder more preferably satisfies L/D = 30 or higher, more preferably L/D = 35 or higher, still more preferably L/D = 40 or higher. L/D means the ratio of effective screw length (L)/screw diameter (D). To improve the kneading performance and the productivity, the melt-kneading is most preferably performed using a twin-screw extruder.

The duration of the melt-kneading is preferably 1 to 600 sec, more preferably 5 to 300 sec. A melt-kneading duration longer than the above duration may cause significant degradation of the resin, and desired performance may not be achieved. A melt-kneading duration shorter than the above duration may cause poor dispersibility, and desired performance may not be achieved.

The temperature in the melt-kneading is required to be not lower than the glass transition temperature of the amorphous resin (A) as well as not lower than the melting point of the fluorine-containing copolymer (B) and is preferably 240°C to 450°C, more preferably 260°C to 400°C.

The first resin composition and the second resin composition of the disclosure may be in any form, and may be in the form of pellet. In other words, a pellet obtainable by molding the first resin composition or the second resin composition of the disclosure is also one aspect of the disclosure.

The pellet of the disclosure may be obtained by kneading the amorphous resin (A) and the fluorine-containing copolymer (B) to prepare the first resin composition of the disclosure or kneading the thermoplastic resin (X) and the fluorine-containing copolymer (B) to prepare the second resin composition of the disclosure, then taking the kneaded mixture from the kneader, and molding it into pellet. The pellet may also be obtained by kneading the amorphous resin (A) and the fluorine-containing copolymer (B) or kneading the thermoplastic resin (X) and the fluorine-containing copolymer (B) using a kneader, then extruding the kneaded mixture by melt extrusion or the like from the kneader, and molding the extruded product.

The molding may be performed by any method and may be performed by melt extrusion using a twin-screw extruder, for example.

The pellet may contain a known component that may be added after the molding into pellet. The addition to the pellet may be performed by a known method, and examples thereof include spraying with a spray to the pellet and dry-blending the pellet with powder of an additive. For example, a lubricant (e.g., magnesium stearate) may be added to the pellet after the molding. A molded article formed from the pellet is excellent in impact strength.

The pellet may be further kneaded after a known component (e.g., a lubricant), which may be post-added, is added to the pellet.

A pellet obtainable by molding the resin composition prepared by the above production method and a pellet containing a lubricant that is added thereto after the molding are also aspects of the disclosure.

Components other than the amorphous resin (A) and the fluorine-containing copolymer (B) may be added to and mixed with the amorphous resin (A) and the fluorine-containing copolymer (B) in advance, or may be added to the amorphous resin (A) and the fluorine-containing copolymer (B) when they are blended. The same applies to the case where the thermoplastic resin (X) is used instead of the amorphous resin (A).

A molded article formed from the first resin composition, the second resin composition, or the pellet of the disclosure is also one aspect of the disclosure.

The molded article formed from the first resin composition or the second resin composition of the disclosure can be commonly obtained by injection molding the pellet. In the injection molding, not only a common cold runner system for molding but also a hot runner system that enables runnerless molding can be used for the production. Furthermore, the injection molding can employ not only a common molding technique but also molding techniques such as gas-assisted injection molding, injection compression molding, ultra-high-speed injection molding, injection press molding, two-color molding, sandwich molding, in-mold coating molding, insert molding, foam molding (including one using a supercritical fluid), rapid heating and cooling molding, insulation molding, and in-mold re-melting molding, and combinations of these. The injection molding can also employ film molding, extrusion molding, electrical wire molding by extrusion, tube molding, and sheet molding.

The molded article of the disclosure preferably has a Charpy strength of 5 KJ/m$^2$ or higher, more preferably 10 KJ/m$^2$ or higher. A higher Charpy impact strength is better, and the upper limit thereof is not limited. For example, the Charpy impact strength may be 100 KJ/m$^2$.

The Charpy strength is a value determined with an impact tester in conformity with ASTM D6110-02.

The molded article of the disclosure has a flexural strength of preferably 1000 MPa or higher, more preferably 2000 MPa or higher. The upper limit is not limited and may be, for example, 3000 MPa.

The flexural strength is a value measured with a universal material testing machine in conformity with ASTM D 790.

The molded article of the disclosure has high flexibility, low relative permittivity, and low dielectric tangent. Thus, the molded article is suitably used as a material required to have dielectric properties (in particular, as a material for high-frequency circuit boards).

High-frequency circuit boards are circuit boards that can be operated in a high frequency band. The high frequency band may be a 1 GHz or higher band, preferably a 3 GHz or higher band, still more preferably a 5 GHz or higher band. The upper limit is not limited and may be a 100 GHz or lower band.

The molded article of the disclosure as a material for high-frequency circuit boards is preferably used in the form of a laminate including metal foil and the molded article of the disclosure.

A laminate including metal foil and the molded article of the disclosure is also one aspect of the disclosure.

Examples of the metal foil include foil of copper, stainless steel, aluminum, iron, silver, gold, and ruthenium. Alloys of the metals are also usable. Copper is preferred among these. Examples of the copper include rolled copper and electrolytic copper.

The laminate of the disclosure is preferably in the form of sheet. The thickness of the laminate may be, for example, 1 $\mu$m to 1 mm, preferably 1 to 500 $\mu$m, more preferably 150 $\mu$m or less, still more preferably 100 $\mu$m or less.

The laminate of the disclosure may include other layers stacked in addition to the metal foil and the molded article of the disclosure.

EXAMPLES

The disclosure is described with reference to, but not limited to, examples.

<Glass transition temperature (Tg)>

The glass transition temperature was measured with a temperature-increasing rate of 20°C/min using a differential scanning calorimeter (DSC) in conformity with JIS K 7121.

<Continuous use temperature>

The continuous use temperature was measured in conformity with UL746B.

<Melt flow rate (MFR)>

The MFRs of the fluorine-containing copolymer and the amorphous resin were measured in conformity with ASTM D1238 after preheating for five minutes and under a load of 5000 g at 380°C or 400°C using a melt indexer. The MFR of a resin composition prepared by mixing the fluorine-containing copolymer and the amorphous resin was also measured as described above.

The measurement temperature was 380°C in examples using the amorphous resin (1) or 400°C in examples using the amorphous resin (2).

<Melting point>

The melting point was determined as the temperature corresponding to the maximum value on a heat-of-fusion curve with a temperature-increasing rate of 10°C/min using a differential scanning calorimeter (DSC).

<Calculation of average dispersed particle size>

Pieces were cut out of the kneaded mixtures (resin compositions) obtained in the examples and the comparative examples, the strands after the MFR measurement of the kneaded mixtures obtained in the examples and the comparative examples, and the injection molded articles (molded articles) obtained in the examples the comparative examples. Then, the pieces were each cut perpendicularly to the flow direction. The cross-section of each piece was photographed using a confocal laser scanning microscope, and the obtained microscopic image was analyzed using image analysis software (Image J). The dispersed phase was selected and the equivalent circle diameter was determined. Circle diameters equivalent to 20 dispersed phases were calculated and averaged to determine the average dispersed particle size r1 and the average dispersed particle size r2.

<Shear rate during kneading>

The shear rate ($\gamma$) during kneading was determined using the following equation 1.

$$\text{Equation 1: } \gamma = \pi D r / C$$

D: screw outer diameter (mm)
r: screw rotation speed (rpm)
C: tip clearance (mm)

<Impact strength (Charpy impact strength)>

A notch was formed in the injection molded article prepared by the method described above. The impact strength of the notched article was measured with an impact tester in conformity with ASTM D6110-02.

<Flexural strength>

The flexural strength of the injection molded article prepared by the method described above was measured with a universal material testing machine in conformity with ASTM D 790. The measurement was performed at a test speed of 2 mm/min.

<Relative permittivity and dielectric tangent>

A strip with a width of 2 mm and a length of 100 mm was cut out of the injection molded article prepared by the method described above. The relative permittivity and the dielectric tangent of the strip were measured by a cavity resonator perturbation method (with network analyzer) at 25°C and 20 GHz.

<IR peak>

A dispersed phase isolated from the resin composition was subjected to IR analysis in conformity with JIS K 0117:2017. The result was expressed based on the following criteria.

o: detection of a peak of the component constituting the continuous phase as well as a peak of the component constituting the dispersed phase
×: detection of only a peak of the component constituting the dispersed phase

No dispersed phase was present in Comparative Example 2 and Comparative Example 5. The dispersed phase could not be isolated in Example 3, Comparative Example 4, Example 5, and Example 8. The IR analysis could not be performed in these examples and comparative examples, and the results were expressed by "-".
The following materials were used in examples and comparative examples.

Amorphous resin (1): PEI (Tg: 217°C, continuous use temperature: 170°C, MFR: 58 g/10 min)
Amorphous resin (2): TPI (Tg: 250°C, continuous use temperature: 240°C, MFR: 50 g/10 min)
Fluorine-containing copolymer (1): FEP (TFE/HFP/PPVE copolymer (containing a reactive functional group), MFR: 30 g/10 min, melting point: 260°C)
Fluorine-containing copolymer (2): PFA (TFE/PAVE copolymer (containing a reactive functional group), MFR: 16 g/10 min, melting point: 306°C)
Fluorine-containing copolymer (3): FEP (TFE/HFP/PPVE copolymer (containing no reactive functional group), MFR: 37 g/10 min, melting point: 260°C)

Examples 1 to 6, Comparative Examples 1 to 4

The materials were dry-blended in the ratio (% by mass) shown in Table 1 or 2 and dried at 120°C for eight hours. The dried mixture was melt-kneaded using a reflux high shear processor available from Niigata Machine Techno Co., Ltd. under the following predetermined conditions to produce a resin composition. The return hole used had a diameter φ of 2.5 mm.

Screw L/D: 1.8
Kneading temperature: 360°C
Shear rate during kneading: shown in Table 1 or 2
Kneading duration: 10 sec

Example 7

A resin composition was produced by preliminary mixing the materials in the ratio (% by mass) shown in Table 2 and then melt-kneading the mixture using a twin screw extruder ($\varphi$: 25 mm, L/D = 52.5) under a cylinder temperature of 360°C and a shear rate of 2090 sec$^{-1}$.

Comparative Example 5, Example 8

A resin composition was produced under the same conditions as in Example 1, except that the materials were dry-blended in the ratio (% by mass) shown in Table 2, and the kneading temperature was 400°C.

<Production of injection molded article>

The resin compositions produced in the examples and the comparative examples were dried at 120°C for eight hours and then injection-molded using a small injection molding machine to obtain ASTM multipurpose test specimens (127 mm $\times$ 12.7 mm $\times$ 3.2 mm).

[Table 1]

| | | | Example 1 | Comparative Example 1 | Comparative Example 2 | Example 2 | Comparative Example 3 | Example 3 | Comparative Example 4 |
|---|---|---|---|---|---|---|---|---|---|
| Formulation | Amorphous resin (1) (PEI) | | 65 | 65 | 100 | 80 | 80 | 20 | 20 |
| | Amorphous resin (2) (TPI) | | - | - | - | - | - | - | - |
| | Fluorine-containing copolymer (1) (FEP) | | - | - | - | - | - | - | - |
| | Fluorine-containing copolymer (2) (PFA) | | 35 | 35 | - | 20 | 20 | 80 | 80 |
| | Fluorine-containing copolymer (3) (FEP) | | - | - | - | - | - | - | - |
| Average dispersed particle size r1 (µm) before MFR | | | 0.32 | 2.00 | - | 0.47 | 1.10 | 2.05 | 1.20 |
| Average dispersed particle size r2 (µm) after MFR | | | 0.44 | 3.40 | - | 0.45 | 2.20 | 1.92 | 12.20 |
| Dispersed particle size ratio (r2/r1) | | | 1.38 | 1.70 | - | 0.96 | 2.00 | 0.94 | 10.10 |
| MFR (g/10 min) | | | 69 | 88 | 58 | 63 | 104 | 75 | 25 |
| Shear rate (sec$^{-1}$) | | | 2560 | 360 | - | 2560 | 360 | 1830 | 360 |
| Impact strength (KJ/m$^2$) | | | 16.0 | 4.6 | 1.4 | 10.0 | 2.3 | 7.0 | 1.5 |
| Flexural strength (MPa) | | | 2497 | 2316 | 3100 | 2600 | 2720 | 1073 | 1100 |
| Relative permittivity | | | 2.7 | 2.7 | 3.1 | 2.8 | 2.8 | 2.3 | 2.3 |
| Dielectric tangent | | | 0.0039 | 0.0039 | 0.0046 | 0.0045 | 0.0042 | 0.0026 | 0.0026 |
| IR peak | | | ○ | × | - | ○ | × | - | - |

[Table 2]

| | | Example 4 | Example 5 | Example 6 | Example 7 | Comparative Example 5 | Example 8 |
|---|---|---|---|---|---|---|---|
| Formulation | Amorphous resin (PEI) | 80 | 20 | 80 | 80 | - | - |
| | Amorphous resin (TPI) | - | - | - | - | 100 | 80 |
| | Fluorine-containing copolymer (1) (FEP) | 20 | 80 | - | 20 | - | 20 |
| | Fluorine-containing copolymer (2) (PFA) | - | - | - | - | - | - |
| | Fluorine-containing copolymer (3) (FEP) | - | - | 20 | - | - | - |
| Dispersed particle size r1 (μm) before MFR | | 0.38 | 1.60 | 0.34 | 0.37 | - | 0.31 |
| Dispersed particle size r2 (μm) after MFR | | 0.43 | 1.27 | 0.38 | 0.37 | - | 0.31 |
| Dispersed particle size ratio (r2/r1) | | 1.13 | 0.79 | 1.12 | 1.00 | - | 1.00 |
| MFR (g/10 min) | | 94 | 121 | 98 | 77 | 50 | 28 |
| Shear rate (sec$^{-1}$) | | 1760 | 1460 | 1600 | 2090 | - | 940 |
| Impact strength (KJ/m$^2$) | | 13 | 5 | 13 | 18 | 7 | 66 |
| Flexural strength (MPa) | | 2700 | 1010 | 2717 | 2836 | 2817 | 2465 |
| Relative permittivity | | 2.9 | 2.3 | 2.7 | 2.8 | 3.1 | 2.8 |
| Dielectric tangent | | 0.0041 | 0.0026 | 0.0056 | 0.0045 | 0.0034 | 0.0032 |
| IR peak | | ○ | - | ○ | ○ | - | - |

A comparison between an example and a comparative example both with the same formulation revealed that the example with a ratio r2/r1 of lower than 1.70 had good impact strength. Examples 1 to 7 were in a tendency of having a higher flexibility, a lower relative permittivity, and a lower dielectric tangent, compared with Comparative Example 2 using an amorphous resin alone. Example 8 had the same tendency as compared with Comparative Example 5.

In Examples 1, 2, 4, 6, 7, and 8 and Comparative Examples 1 and 3 in which the amount of the amorphous resin (A) was larger than the amount of the fluorine-containing copolymer (B), the amorphous resin (A) formed a continuous phase, while the fluorine-containing copolymer (B) formed a dispersed phase. In Examples 3 and 5 and Comparative Example 4 in which the amount of the amorphous resin (A) was smaller than the amount of the fluorine-containing copolymer (B), the fluorine-containing copolymer (B) formed a continuous phase, while the amorphous resin (A) formed a dispersed phase.

Examples 1, 2, 4, 6, and 7 obtained the criterion o in the IR peak analysis. In the examples, the component constituting the continuous phase was present in the dispersed phase. Although the IR analysis could not be performed in Examples 3, 5, and 8, the improvement observed in other examples was achieved, suggesting the presence of the component constituting the continuous phase in the dispersed phase.

EMBODIMENTS

Embodiment 1. A resin composition, comprising:

an amorphous resin (A) belonging to super engineering plastics; and
a fluorine-containing copolymer (B),
the amorphous resin (A) or the fluorine-containing copolymer (B) having an average dispersed particle size r1 and an average dispersed particle size r2 that is determined after measuring a melt flow rate in conformity with ASTM D1238 after preheating for five minutes and under a load of 5000 g at 380°C or at a temperature at which the resin composition melts or higher,
the r1 and the r2 satisfying a ratio r2/r1 of lower than 1.70, where the r1 and the r2 are obtained by measuring the same resin or the same copolymer.

Embodiment 2. The resin composition according to Embodiment 1, wherein the amorphous resin (A) has a glass transition temperature of 190°C to 290°C.

Embodiment 3. The resin composition according to Embodiment 1 or 2, wherein the amorphous resin (A) has a continuous use temperature of 140°C or higher.

Embodiment 4. The resin composition according to any one of Embodiments 1 to 3, wherein the amorphous resin (A) has an imide structure.

Embodiment 5. The resin composition according to Embodiment 4, wherein the amorphous resin (A) has an amide structure and an imide structure.

Embodiment 6. The resin composition according to Embodiment 4 or 5, wherein the amorphous resin (A) is a thermoplastic polyimide.

Embodiment 7. The resin composition according to any one of Embodiments 4 to 6, wherein the amorphous resin (A) is polyetherimide.

Embodiment 8. The resin composition according to any one of Embodiments 1 to 7, wherein the fluorine-containing copolymer (B) has a melting point of 200°C to 323°C.

Embodiment 9. The resin composition according to any one of Embodiments 1 to 8, wherein the fluorine-containing copolymer (B) is a copolymer of tetrafluoroethylene and a perfluoroethylenic unsaturated compound represented by the following formula (1):

$$CF_2=CF\text{-}Rf^1 \qquad (1)$$

wherein $Rf^1$ is $-CF_3$ or $-ORf^2$, where $Rf^2$ is a C1-C5 perfluoroalkyl group.

Embodiment 10. The resin composition according to Embodiment 9, wherein the perfluoroethylenic unsaturated compound is at least one selected from the group consisting of hexafluoropropylene and perfluoro(alkyl vinyl ether).

Embodiment 11. The resin composition according to Embodiment 9 or 10, wherein the fluorine-containing copolymer (B) is at least one selected from the group consisting of a tetrafluoroethylene/hexafluoropropylene copolymer and a tetrafluoroethylene/perfluoro(alkyl vinyl ether) copolymer.

Embodiment 12. The resin composition according to any one of Embodiments 1 to 11,

wherein the r2 is 2.0 $\mu$m or less when the r1 and the r2 are obtained by measuring the amorphous resin (A), or the r2 is 1.0 $\mu$m or less when the r1 and the r2 are obtained by measuring the fluorine-containing copolymer (B).

Embodiment 13. The resin composition according to any one of Embodiments 1 to 12, wherein the amorphous resin (A) and the fluorine-containing copolymer (B) are in a mass ratio (A): (B) of 99:1 to 10:90.

Embodiment 14. The resin composition according to Embodiment 13,

wherein the mass ratio (A): (B) is 80:20 to 20:80.

Embodiment 15. The resin composition according to any one of Embodiments 1 to 14, wherein the resin composition has a phase structure including a continuous phase and a dispersed phase that contains a component constituting the continuous phase.

Embodiment 16. A resin composition, comprising:

a thermoplastic resin (X); and
a fluorine-containing copolymer (B),
the resin composition having a phase structure including a continuous phase and a dispersed phase that contains a component constituting the continuous phase, where one of the thermoplastic resin (X) and the fluorine-containing copolymer (B) forms the continuous phase and the other forms the dispersed phase.

Embodiment 17. A method for producing the resin composition according to any one of Embodiments 1 to 15, the method comprising melt-kneading the amorphous resin (A) and the fluorine-containing copolymer (B) at a shear rate of 600/sec or higher determined using the following equation 1.

$$\text{Equation 1: } \gamma = \pi D r / C$$

y:    shear rate (/sec)
D:    screw outer diameter (mm)
r:    screw rotation speed (rpm)
C:    tip clearance (mm)

Embodiment 18. The production method according to Embodiment 17,

wherein the shear rate is 800/sec or higher and 3000/sec or lower,
the duration of the melt-kneading is 5 to 300 seconds, and
the temperature in the melt-kneading is 260°C to 400°C.

Embodiment 19. A pellet obtained by molding the resin composition according to any one of Embodiments 1 to 16.

Embodiment 20. A molded article formed from the resin composition according to any one of Embodiments 1 to 16.

Embodiment 21. The molded article according to Embodiment 20, having a Charpy impact strength of 5 kJ/m$^2$ or higher as measured with an impact tester in conformity with ASTM D6110-02.

Embodiment 22. The molded article according to Embodiment 20 or 21, which is used as a material required to have dielectric properties.

Embodiment 23. The molded article according to any one of Embodiments 20 to 22, which is a material for high-frequency circuit boards.

Embodiment 24. A laminate, comprising:

metal foil; and
the molded article according to any one of Embodiments 20 to 23.

Embodiment 25. The laminate according to Embodiment 24, wherein the metal foil is formed of copper.

**Claims**

1. A composition, which is a resin composition comprising a thermoplastic resin (X); and a fluorine-containing copolymer (B),
   the resin composition having a phase structure including a continuous phase and a dispersed phase that contains a component constituting the continuous phase, where one of the thermoplastic resin (X) and the fluorine-containing copolymer (B) forms the continuous phase and the other forms the dispersed phase.

2. A pellet obtained by molding the composition of claim 1.

3. A molded article formed from the composition of any of claims 1 or 2, preferably a molded article having a Charpy impact strength of $\geq 5$ kJ/m$^2$, measured with an impact tester in conformity with ASTM D6110-02.

4. The use of the molded article of claim 3 as a material required to have dielectric properties, preferably a material for high-frequency circuit boards.

5. A laminate, comprising metal foil, preferably metal foil is formed of copper, and the molded article of claim 3.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001072882 A
- JP 2005313608 A
- JP 2011046103 A